(19) Europäisches Patentamt / European Patent Office / Office européen des brevets

(11) **EP 2 937 704 B1**

(12) **EUROPÄISCHE PATENTSCHRIFT**

(45) Veröffentlichungstag und Bekanntmachung des Hinweises auf die Patenterteilung:
**22.03.2017 Patentblatt 2017/12**

(51) Int Cl.:
*G01R 31/08* *(2006.01)*    *G01R 27/02* *(2006.01)*

(21) Anmeldenummer: **14165769.2**

(22) Anmeldetag: **24.04.2014**

(54) **Verfahren und Anordnung zum Erkennen von Fehlern auf einer mehrphasigen elektrischen Energieübertragungsleitung**

Method and assembly for detecting faults on a multiphase electric energy transmission line

Procédé et agencement de reconnaissance d'erreurs sur une ligne de transport d'énergie électrique

(84) Benannte Vertragsstaaten:
**AL AT BE BG CH CY CZ DE DK EE ES FI FR GB GR HR HU IE IS IT LI LT LU LV MC MK MT NL NO PL PT RO RS SE SI SK SM TR**

(43) Veröffentlichungstag der Anmeldung:
**28.10.2015 Patentblatt 2015/44**

(73) Patentinhaber: **Siemens Aktiengesellschaft**
**80333 München (DE)**

(72) Erfinder:
- **Blumschein, Jörg**
  **14165 Berlin (DE)**
- **Dzienis, Cezary**
  **14624 Dallgow-Döberitz (DE)**
- **Yelgin, Yilmaz**
  **13589 Berlin (DE)**
- **Claus, Michael**
  **90482 Nürnberg (DE)**
- **Kereit, Matthias**
  **12159 Berlin (DE)**
- **Steynberg, Gustav**
  **91338 Igensdorf (DE)**
- **Westermann, Robert**
  **39221 Kleinmühlingen Bördeland (DE)**

(56) Entgegenhaltungen:
**EP-A1- 2 113 778      US-A- 4 559 491**
**US-A1- 2004 167 729**

- **Jan Izykowski: "Fault location on power transmission lines" In: "Fault location on power transmission lines", 31. Dezember 2008 (2008-12-31), Oficyna Wydawnicza Politechniki Wroclawskiej, Wrozlaw 2008, Wrozlaw, Poland, XP055142324, ISBN: 978-8-37-493430-5 Seiten 1-223, * Seite 96 - Seite 99 * * Absatz [06.4] - Absatz [06.5]; Abbildungen 6.1-6.3; Tabellen 6.3-6.7 ***

EP 2 937 704 B1

**Beschreibung**

Es ist bekannt, zum Erkennen von einpoligen Fehlern auf einer mehrphasigen elektrischen Energieübertragungsleitung die Reaktanz der jeweils von dem Fehler betroffenen Schleifen zu berechnen und dabei zur Vermeidung eines Lasteinflusses oder zur Vermeidung einer Fehlberechnung bei einem Kurzschluss mit Übergangswiderstand unter Benutzung des Systems der symmetrischen Komponenten die Reaktanz der betroffenen Leiterschleife zu berechnen.

Der Erfindung liegt die Aufgabe zugrunde, ein Verfahren zum Erkennen von Fehlern auf einer mehrphasigen elektrischen Energieübertragungsleitung anzugeben, mit dem die Reaktanz auch bei mehrpoligen Fehlern genau bestimmt werden kann.

Zur Lösung dieser Aufgabe ist erfindungsgemäß ein Verfahren zum Erkennen von Fehlern auf einer mehrphasigen elektrischen Energieübertagungsleitung mittels Erfassung fehlerabhängiger Ströme und Spannungen geeignet, bei dem zur Bestimmung der *Reaktanz* $X_{Lxy}$ der Energieübertragungsleitung (L) bei einem zweipoligen Fehler an einem Ende (A) der Energieübertragungsleitung ein Phase-Phase-Spannungszeiger $\underline{U}_{LxLy}$ der vom Fehler betroffenen Phasen, aus den Phasenströmen $\underline{I}_{Lx}, \underline{I}_{Ly}$ in den vom Fehler betroffenen Phasen ein Differenzstromzeiger $(\underline{I}_{Lx} - \underline{I}_{Ly})$ sowie ein Fehlerstromzeiger $\underline{I}_{Fsub}$ gebildet werden, der als eine Funktion des Gegensystems gemäß der Methode der symmetrischen Komponenten mit Abhängigkeit vom Gegensystemstrom und einem Kompensationswinkel $\delta_2$ für das Gegensystem dargestellt wird; gemäß folgender Gleichung wird die Reaktanz $X_{Lxy}$ der Energieübertragungsleitung bestimmt

$$X_{Lxy} = \sin(\varphi) \frac{\operatorname{Im}\{\underline{U}_{LxLy} \cdot (\underline{I}_{Fsub} \cdot e^{j\delta_2})^*\}}{\operatorname{Im}\{\underline{Z}_L / |\underline{Z}_L| \cdot (\underline{I}_{Lx} - \underline{I}_{Ly}) \cdot (\underline{I}_{Fsub} \cdot e^{j\delta_2})^*\}}$$

mit

$\underline{Z}_L$ als Impedanz der Energieübertragungsleitung,
$\varphi$ als Phasenwinkel der Impedanz der Energieübertragungsleitung,
Im als Bezeichnung für den Imaginärteil und
*als konjugiert komplexer Anteil.

Für die Berechnung der symmetrischen Komponente wird bei zweipoligen Fehler, mit und ohne Erdbeteiligung, die fehlerfremde Phase als Bezug angewendet.

Ein Vorteil des erfindungsgemäßen Verfahrens besteht darin, dass es bei zweipoligen Fehlern auf einer mehrphasigen Energieübertragungsleitung die Möglichkeit bietet, die Reaktanz auch dann genau zu ermitteln, wenn durch Lasteinfluss von nicht am Fehler bzw. Kurzschluss beteiligten Schleifen Scheinimpedanzen gebildet werden oder Netzpendelungen auftreten; auch ein Kurzschluss mit Übergangswiderstand wirkt sich nicht nachteilig auf die Genauigkeit bei der Ermittlung der mit dem erfindungsgemäßen Verfahren bestimmten Reaktanz aus.

Bei einer vorteilhaften Weiterbildung des erfindungsgemäßen Verfahrens erfolgt unter Ausbildung eines Distanzschutzverfahrens die Bestimmung der Resistanz der Energieübertragungsleitung bei dem zweipoligen Fehler gemäß der nachstehenden Gleichung

$$R_{Lxy} = \frac{\operatorname{Im}\{\underline{U}_{LxLy} \cdot [\{\underline{Z}_L (\underline{I}_{Lx} - \underline{I}_{Ly})\}^*\}}{\operatorname{Im}\{[2(\underline{a} - \underline{a}^2)\underline{I}_{2,A} + (\underline{a} - \underline{a}^2)\underline{I}_{0,A}] \cdot [\{\underline{Z}_L (\underline{I}_{Lx} - \underline{I}_{Ly})\}^*\}}\ ,$$

in der bezeichnen

$\underline{a}$ einen komplexen Drehfaktor,
$\underline{I}_{2,A}$ einen Gegensystemstrom der symmetrischen Komponenten und
$\underline{I}_{0,A}$ einen Strom des Nullsystems der symmetrischen Komponenten, und

die Resistanz $R_{Lxy}$ mit der Reaktanz $X_{Lxy}$ zur Impedanzbestimmung heran gezogen wird. Die übrigen Größen sind bereits oben erläutert.

Damit ist ein Distanzschutzverfahren geschaffen, das auch bei Fehlern an den Grenzen seines Auslösegebietes sehr genau arbeitet und somit weder eine nennenswerte Über- noch Unterfunktion aufweist und daher Fehler vorgabegetreu erfasst bzw. außerhalb seines Auslösegebietes liegende Fehler genau als nicht zu erfassen einordnet.

Vorteilhaft ist es ferner, wenn bei dem erfindungsgemäßen Verfahren der Kompensationswinkel $\delta_2$ des Ge-

gensystems gemäß der nachstehenden Gleichung bestimmt wird:

$$\delta_2 = \frac{\underline{Z}_{2,A} + \underline{Z}_{2,B} + \underline{Z}_{2,L}}{(1-m)\cdot \underline{Z}_{2,L} + \underline{Z}_{2,B}} \ ,$$

in der bezeichnen

$m$      den Fehlerort als Bruchteil der gesamten Länge der Energieübertragungsleitung (L),
$\underline{Z}_{2,A}$      die Impedanz im Gegensystem bezogen auf das eine Ende der Energieübertragungsleitung,
$\underline{Z}_{2,B}$      die Impedanz im Gegensystem bezogen auf das andere Ende der Energieübertragungsleitung und
$\underline{Z}_{2,L}$      die Leitungsimpedanz im Gegensystem.

Wird dabei als der Kompensationswinkel ein Kompensationswinkel $\delta_2$ berücksichtigt, wie er sich für die Grenze des Auslösegebietes berechnen lässt, dann ist für diesen kritischen Bereich die angestrebte Genauigkeit erzielbar.

Eine weitere Lösung der eingangs angegebenen Aufgabe besteht in einem Verfahren zum Erkennen von mehrpoligen Fehlern auf einer mehrphasigen elektrischen Energieübertagungsleitung mittels Erfassung fehlerabhängiger Ströme und Spannungen, bei dem zur Bestimmung der Reaktanz $X_{Lxy}$ der Energieübertragungsleitung bei einem dreipoligen Fehler

an einem Ende der Energieübertragungsleitung aus den Phasenspannungen der Energieübertragungsleitung ein Mitsystemspannungs-Zeiger $\underline{U}_{1,A}$, aus den Phasenströmen ein Mitsystemstrom-Zeiger $\underline{I}_{1,A}$ und aus dem Mitsystemstrom-Zeiger vor dem Fehler und einem Mitsystemstrom-Zeiger während des Fehlers ein Deltastrom-Zeiger $\Delta\underline{I}_{1,A}$ unter Berücksichtigung des Kompensationswinkel $\delta_2$ für das Gegensystem gebildet werden, und gemäß folgender Gleichung die Reaktanz $X_L$ der Energieübertragungsleitung bestimmt wird

$$X_L = \sin(\varphi) \frac{\mathrm{Im}\{\underline{U}_{1,A} \cdot (\Delta\underline{I}_{1,A} \cdot e^{j\delta_2})^*\}}{\mathrm{Im}\{\underline{Z}_1 / |\underline{Z}_1| \cdot \underline{I}_{1,A} \cdot (\Delta\underline{I}_{1,A} \cdot e^{j\delta_2})^*\}}$$

mit

     Z1 als Mitsystemimpedanz der Energieübertragungsleitung,
     Im als Bezeichnung für den Imaginärteil und
     *als konjugiert komplexer Anteil. Zu den übrigen Größen siehe die obigen Erläuterungen.

Mit diesem Verfahren für dreipolige Fehler ergeben sich sinngemäß dieselben Vorteile, wie sie oben zu dem Verfahren zum Bestimmen der Reaktanz bei einem zweipoligen Fehler angegeben sind.

In vorteilhafter Weise lässt sich auch das Verfahren zur Bestimmung der Reaktanz bei einem dreipoligen Fehler zu einem genau arbeitenden Distanzschutzverfahren ausgestalten, wenn die Bestimmung der Resistanz $R_F$ der Energieübertragungsleitung bei dem dreipoligen Fehler gemäß der nachstehenden Gleichung erfolgt

$$R_F = \frac{\mathrm{Im}\{\underline{U}_{1,A} \cdot [\underline{Z}_L \underline{I}_{1,A}]^*\}}{\mathrm{Im}\{\Delta\underline{I}_{1,A} \cdot [\underline{Z}_L \underline{I}_{1,A}]^*\}}$$

und die Resistanz $R_F$ mit der *Reaktanz $X_L$* zur Impedanzbestimmung heran gezogen wird.

Vorteilhaft ist es dabei, den Kompensationswinkel $\delta_2$ des Gegensystems gemäß der nachstehenden Gleichung zu bestimmen:

$$\delta_2 = \frac{\underline{Z}_{2,A} + \underline{Z}_{2,B} + \underline{Z}_{2,L}}{(1-m)\cdot \underline{Z}_{2,L} + \underline{Z}_{2,B}} \ ,$$

in der bezeichnen

$\underline{Z}_{2,A}$      die Impedanz im Gegensystem bezogen auf das eine Ende der Energieübertragungsleitung,

$\underline{Z}_{2,B}$ die Impedanz im Gegensystem bezogen auf das andere Ende der Energieübertragungsleitung und

$\underline{Z}_{2,L}$ die Leitungsimpedanz im Gegensystem.

Wird dabei ein Kompensationswinkel berücksichtigt, wie er sich für die Grenze des Auslösegebietes berechnen lässt, dann ist auch für den dreipoligen Fehler für diesen kritischen Bereich die angestrebte Genauigkeit erzielbar.

Besonders vorteilhaft lässt sich das erfindungsgemäße Verfahren zum Erkennen von mehrpoligen Fehlern hinsichtlich ihres Fehlerortes auf der mehrphasigen elektrischen Energieübertagungsleitung einsetzen, wenn eine den Reaktanzbelag der gesamten Energieübertragungsleitung angebende Belag-Größe x' verwendet wird, die Reaktanz $X_{Lxy}$ der Energieübertragungsleitung im Fehlerfall mit einem dem Kehrwert der Belag-Größe x' entsprechenden Wert multipliziert wird und

unter Ausnutzung der Fehlerortsabhängigkeit des Kompensationswinkels $\delta_2$ des Gegensystems der Fehlerort nach einem Iterationsverfahren bestimmt wird.

Als Iterationsverfahren kommen verschiedene Verfahren in Frage, beispielsweise die Newton-Raphson-Methode, die sehr schnell konvergiert, jedoch rechnerisch sehr aufwendig ist. Bevorzugt wird die Gauß-Methode, die rechnerisch weniger anspruchsvoll ist; dass das Ergebnis bei dieser Methode zeitlich etwas verzögert im Vergleich zur Newton-Raphson-Methode vorliegt, spielt bei der Fehlerortung keine Rolle, weil die Fehlerortung ohne Zeitdruck nach dem Abschalten der fehlerbefallenen Energieübertragungsleitung durchgeführt wird.

Im Einzelnen lässt sich die Fehlerortung gemäß der Erfindung in der Weise durchführen, dass während eines zweipoligen Fehlers an dem anderen Ende der Energieübertragungsleitung der Impedanz-Zeiger $\underline{Z}_{2,B}$ im Gegensystem aus dem Gegensystemspannungs-Zeiger $\underline{U}_{2,B}$ und dem Gegensystemstrom-Zeiger $\underline{I}_{2,B}$ gebildet und abgespeichert wird und mit der gespeicherten Information über den zweipoligen Fehler zu dem einen Ende der Energieübertragungsleitung übertragen wird.

In ähnlicher Weise wird bei dem erfindungsgemäßen Verfahren die Fehlerortung bei einem dreipoligen Fehler vorgenommen, indem während eines dreipoligen Fehlers an dem anderen Ende der Energieübertragungsleitung der Impedanz-Zeiger $\Delta\underline{Z}_{1,B}$ im Delta-Mitsystem aus dem Delta-Mitsystemspannungs-Zeiger $\Delta\underline{U}_{1,B}$ und dem Delta-Mitsystemstrom-Zeiger $\Delta\underline{I}_{1,B}$ gebildet und abgespeichert wird und mit der gespeicherten Information über den dreipoligen Fehler zu dem einen Ende der Energieübertragungsleitung übertragen wird.

Die Übertragung der am anderen Ende der Energieübertragungsleitung abgespeicherten Impedanzgrößen und der Information über den zweipoligen oder dreipoligen Fehler zu dem einen Ende der Energieübertragungsleitung kann in unterschiedlicher Weise erfolgen, beispielsweise durch Übernahme dieser Informationen in einen tragbaren Rechner, beispielsweise einen Störschreiber, Transport diese Rechners zu dem einen Ende der Energieübertragungsleitung und Übergabe dieser Informationen an diesem Ende. Zeit dafür ist ausreichend vorhanden.

Im Hinblick auf eine umgehende und bequeme Fehlerortsbestimmung ist es jedoch vorteilhaft, wenn der jeweils abgespeicherte Impedanz-Zeiger und die jeweils gespeicherte Information über den zweipoligen oder dreipoligen Fehler über eine Datenleitung zu dem anderen Ende der Energieübertragungsleitung übertragen werden. Dazu ist eine Datenleitung mit geringer Übertragungsqualität ausreichend, weil nur wenige Informationen übertragen werden müssen.

Es ist zwar aus der deutschen Offenlegungsschrift DE 196 05 022 A1 bekannt, in Messanordnungen an dem Enden einer zu überwachenden Energieübertragungsleitung zur Fehlerortsbestimmung Zwischengrößen zu bilden und bereitzustellen, die über eine Datenleitung mit geringer übertragungskapazität übertragbar sind, jedoch ist nicht im Einzelnen angegeben, um welche Zwischengrößen es sich handelt.

Generell ist zu dem erfindungsgemäßen Verfahren anzumerken, dass es zur Bildung der verschiedenen, oben angesprochenen Zeiger und zur Berechnung der Reaktanzen, Resistanzen und des Fehlerortes geeignet ist, mit einem Rechner, vorzugsweise einem Personal Computer, mindestens an dem einen Ende der Energieübertragungsleitung durchgeführt zu werden.

In diesem Zusammenhang ist ein Computerprogramm vorteilhaft, das direkt in den internen Speicher des Rechners geladen werden kann und einen Computercodeabschnitt umfasst, um die oben angegebenen Schritte zu steuern, wenn das Programm auf dem Rechner abläuft.

Der Erfindung liegt ferner die Aufgabe zugrunde, eine Anordnung anzugeben, mit der ein Fehler hinsichtlich seines Fehlerorts bei mehrpoligen Fehlern genau bestimmt werden kann.

Zur Lösung dieser Aufgabe ist eine Anordnung zur Durchführen des erfindungsgemäßen Verfahrens geeignet, bei der an dem einen Ende der mehrphasigen elektrischen Energieübertragungsleitung eine Messwertaufbereitungs-Einrichtung vorhanden ist, die bei einem zweipoligen Fehler den Phase-Phase-Spannungszeiger $\underline{U}_{Lx,Ly}$, den Differenz-strom-Zeiger $\underline{I}_{Lx}$, - $\underline{I}_{Ly}$ und den Fehlerstromzeiger $\underline{I}_{Fsub}$ bildet und bei einem dreipoligen Fehler den Mitsystemspannungs-Zeiger $\underline{U}_{1,B}$, den Mitsystemstrom-Zeiger $\underline{I}_{1,B}$ und den Deltastrom-Zeiger $\Delta\underline{I}_{1,B}$ bildet und an dem anderen Ende der Energieübertragungsleitung eine weitere Messwertaufbereitungs-Einrichtung vorgesehen ist, die während eines zweipoligen Fehlers den Impedanz-Zeiger $\underline{Z}_{2,B}$ im Gegensystem bildet und abspeichert und bei einem dreipoligen Fehler den Impedanz-Zeiger $\Delta\underline{Z}_{2,B}$ im Delta-System bildet und abspeichert sowie eine Information über die Art des Fehlers speichert; ferner ist eine Datenübertragungseinrichtung zur Übertragung der in der weiteren Messwertaufbereitungseinrichtung gespeicherten Daten zu dem einen Ende der Energieübertragungsleitung vorhanden und an die eine Messwertübertragungseinrichtung ist eine auch mit der Datenübertragungseinrichtung verbundene Auswerteeinrichtung angeschlossen ist, die geeignet ist, den Ort des Fehlers bei einem zweipoligen Fehler gemäß der nachstehenden Gleichung

$$f_{Lxy}(m) = \sin(\varphi) \frac{\text{Im}\{\underline{U}_{LxLy} \cdot (\underline{I}_{Fsub} \cdot e^{j\delta_2(m)})^*\}}{x' \cdot \text{Im}\{\underline{Z}_L / |\underline{Z}_L| \cdot (\underline{I}_{Lx} - \underline{I}_{Ly}) \cdot (\underline{I}_{Fsub} \cdot e^{j\delta_2(m)})^*\}}$$

und bei einem dreipoligen Fehler gemäß der folgenden Gleichung

$$f_L(m) = \sin(\varphi) \frac{\text{Im}\{\underline{U}_{1,A} \cdot (\Delta\underline{I}_{1,A} \cdot e^{j\delta_2(m)})^*\}}{x' \cdot \text{Im}\{\underline{Z}_1 / |\underline{Z}_1| \cdot \underline{I}_{1,A} \cdot (\Delta\underline{I}_{1,A} \cdot e^{j\delta_2(m)})^*\}}$$

nach einem Iterationsverfahren zu bestimmen.

Die mit der erfindungsgemäßen Anordnung erzielbaren Vorteile entsprechen sinngemäß den Vorteilen, die oben im Zusammenhang mit dem erfindungsgemäßen Verfahren zum Erkennen von Fehlern hinsichtlich ihres Fehlerorts angegeben sind.

Bei der erfindungsgemäßen Anordnung ist vorteilhafterweise an die weitere Messwertaufbereitungs-Einrichtung eine weitere Auswerteeinrichtung angeschlossen, die entsprechend der einen Auswerteeinrichtung ausgebildet ist. Dies ist zur Vermeidung unterschiedlicher Ausführungen der Messwertaufbereitungs-Einrichtung vorteilhaft. Es kann aber auch vorteilhaft sein, die weitere Messwertaufbereitungs-Einrichtung sparsam nur im Hinblick auf die Bildung der an dem anderen Ende der Energieübertragungsleitung zu ermittelnden Zeiger auszugestalten.

Vorteilhaft erscheint es ferner aus Kostengründen, wenn mindestens die eine Auswerteeinrichtung ein Personal Computer ist.

Ferner wird es als vorteilhaft angesehen, wenn bei der erfindungsgemäßen Anordnung die Datenübertragungseinrichtung eine Datenübertragungsleitung ist.

Zur weiteren Erläuterung der Erfindung zeigen

Fig. 1    eine Anordnung zum Durchführen des erfindungsgemäßen Verfahrens,
Fig.2    ein Ersatzschaltbild eines zweipoligen Fehlers ohne Erdbeteiligung bei zweiseitiger Einspeisung im System der symmetrischen Komponenten,
Fig. 3    ein Ersatzschaltbild eines zweipoligen Fehlers mit Erdbeteiligung bei zweiseitiger Einspeisung wiederum im System der symmetrischen Komponenten und in
Fig. 4    ein Ersatzschaltbild eines dreipoligen Fehlers in Delta-Komponenten des Mitsystems.

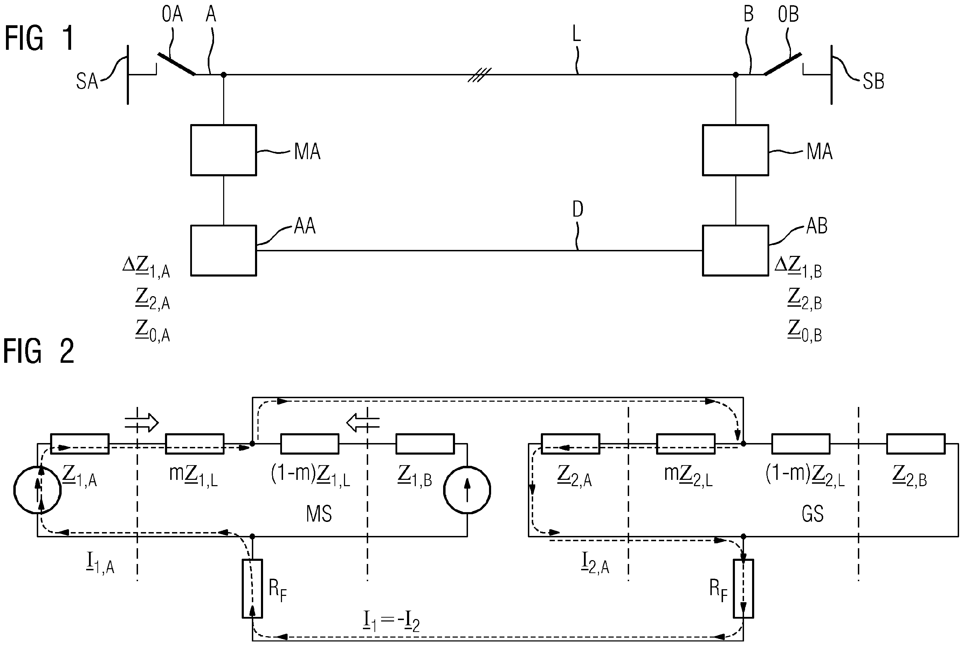

Fig. 1 zeigt eine mehrphasige bzw. dreiphasige elektrische Energieübertragungsleitung L, die im gezeigten Beispiel zwischen einer ersten Sammelschiene SA und einer zweiten Sammelschiene SB verläuft, also mit ihrem einen Ende A über eine Schalteranordnung OA mit der einen Sammelschiene SA und mit ihrem anderen Ende B über eine weitere Schalteranordnung OB mit der anderen Sammelschiene SB verbunden ist.

An dem einen Ende A der Energieübertragungsleitung L ist eine Messwertaufbereitungs-Einrichtung MA angeschlossen, die unter anderem eine nicht dargestellte Anregeschaltung enthält, die beim Auftreten eines Fehlers auf der Energieübertragungsleitung L die vom Fehler betroffenen Phasen der Energieübertragungsleitung L auswählt und dafür sorgt, dass die im jeweiligen Fehlerfall an dem Ende A zu messende Ströme und Spannungen der Messwertaufbereitungs-Einrichtung MA zur Verfügung stehen.

Entsprechend ist an dem weiteren Ende B der Energieübertragungsleitung L eine weitere Messwertaufbereitungs-Einrichtung MB vorgesehen, die ebenfalls mit einer nicht gezeigten Anregeschaltung versehen ist, um im jeweiligen Fehlerfall an dem Ende B zu messende Ströme und Spannungen der Messwertaufbereitungs-Einrichtung MB zur Verfügung zu stellen.

An die Messwertaufbereitungs-Einrichtung MA ist eine Auswerteinrichtung AA angeschlossen, in der - wie unten erläutert wird - Zeiger aus den gemessenen Strömen und Spannungen bestimmt und verrechnet werden und auch der Fehlerort errechnet werden kann.

Zunächst soll der Fall eines zweipoligen Fehlers auf der Energieübertragungsleitung L behandelt werden:

Tritt ein solcher Fehler, der auch als ein Phase-Phase-Fehler bezeichnet werden kann, auf der dreiphasigen Energieübertragungsleitung L mit den Phasen Lx, Ly und Lz zwischen den Phasen Lx und Ly auf, dann lassen sich die Spannungs- bzw. Stromverhältnisse durch die folgende Gleichung (1) beschreiben

$$\underline{U}_{LxLy} = \underline{Z}_L(\underline{I}_{Lx} - \underline{I}_{Ly}) + \underline{I}_F \cdot R_F \tag{1}$$

mit

$I_F$      Fehlerstrom am Ort des Fehlers,
$\underline{Z}_L$      Impedanz der Energieübertragungsleitung L,
$\underline{U}_{LxLy}$      Spannung zwischen der Phase Lx und der Phase Ly,
$\underline{I}_{Lx}, \underline{I}_{Ly}$      Strom in der Phase Lx, Strom in der Phase Ly und
$R_F$      Fehlerwiderstand (Widerstand am Fehlerort).

$I_F$ ist als Differenz der Ströme der beiden am Fehler beteiligten Phasen Lx und Ly am Fehlerort bzw. an der Fehlerstelle zu verstehen. Diese Ströme sind wegen der zweiseitigen Einspeisung unbekannt. Um die oben angegebene Gleichung zu lösen, wird ein Ersatzschaltbild durch symmetrische Komponenten verwendet (siehe Fig.2).
Die Berechnung der symmetrischen Komponenten erfolgt nach den in der Literatur bereits bekannten Formeln. Der Strom in der Referenzphase, das ist bei dem angenommenen zweipoligen Fehler in den Phasen Lx und Ly die Phase Lz, lässt sich als eine einfache Summe aller symmetrischen Komponenten darstellen. Die Darstellung der Ströme $\underline{I}_{Lx}$ und $\underline{I}_{Ly}$ in den fehlerbehafteten Phasen Lx und Ly ist eine lineare Kombination der symmetrischen Komponenten. Da bei dem hier behandelten zweipoligen Fehler ohne Erdbeteiligung kein Erdstrom fließt, lassen sich die zum Fehlerstrom $\underline{I}_F$ beitragenden Ströme $\underline{I}_{FLx}$ und $\underline{I}_{FLy}$ durch folgende Beziehungen beschreiben:

$$\underline{I}_{FLx} = \underline{a}^2 \underline{I}_1 + \underline{a} I_2$$
$$\underline{I}_{FLy} = \underline{a} \underline{I}_1 + \underline{a}^2 \underline{I}_2 \tag{2}$$

wobei $\underline{a}$ ein komplexer Drehfaktor ist und $\underline{I}_1$ und $\underline{I}_2$ Ströme des komplexen Mitsystems MS und des komplexen Gegensystem GS darstellen. Da bei einem zweipoligen Fehler ohne Erdbeteiligung das Mit- und Gegensystem die gleiche Amplitude besitzen (der Laststrom ist vernachlässigt bzw. eliminiert, da nur der Gegensystembetrag betrachtet wird), lässt sich die Stromdifferenz $\underline{I}_{FLx}-\underline{I}_{FLy}$ in folgender Gleichung zusammenfassen:

$$\underline{I}_F = \underline{I}_{FLx} - \underline{I}_{FLy} = 2(\underline{a} - \underline{a}^2)\underline{I}_2 \tag{3}$$

Da sich der gesamte Fehlerstrom $\underline{I}_F$ nicht allein von einem Ende der Energieübertragungsleitung L aus, z. B. vom Ende A, ermitteln lässt, muss eine Annäherung vorgenommen werden. Diese besteht darin, dass man den tatsächlichen Fehlerstrom $\underline{I}_F$ durch einen Strom $\underline{I}_{Fsub}$ substituiert und den substituierten Strom $\underline{I}_{Fsub}$ als eine Funktion des Gegensystems darstellt:

$$\underline{I}_F \approx \underline{I}_{Fsub} = 2(\underline{a} - \underline{a}^2)\underline{I}_{2,A} \cdot e^{j\delta_2} \tag{4}$$

wobei $\underline{I}_{2,A}$ der Strom des Gegensystems GS und $\delta_2$ ein Kompensationswinkel für das Gegensystem GS ist. Dieser Winkel lässt sich mit folgender Formel berechnen:

$$\delta_2 = \frac{\underline{Z}_{2,A} + \underline{Z}_{2,B} + \underline{Z}_{2,L}}{(1-m) \cdot \underline{Z}_{2,L} + \underline{Z}_{2,B}} \tag{5}$$

wobei

m      die (normierte) Entfernung des Fehlers von dem einen Ende A der Energieübertragungsleitung L,
$\underline{Z}_{2,A}$      die Impedanz im Gegensystem GS bezogen auf das eine Ende A der Energieübertragungsleitung L,

$\underline{Z}_{2,B}$      die Impedanz im Gegensystem GS bezogen auf das andere Ende B der Energieübertragungsleitung L und

$\underline{Z}_{2,L}$      die Leitungsimpedanz im Gegensystem GS

ist.

Da die Entfernung m des Fehlers nicht bekannt ist, sollte sich bei einer Ausführung des Verfahrens als Distanzschutzverfahren die Berechnung des Kompensationswinkels $\delta_2$ auf das Ende der Distanzschutzzone beziehen. Da das Gegensystem GS völlig von der Last entkoppelt ist, bewirkt dieser Winkel $\delta_2$ eine lastunabhängige Phasendrehung des Gegensystems GS zur Phase des tatsächlichen Kurzschlussstromes an der Fehlerstelle. Durch die Multiplikation der Formel (1) mit dem konjugiert komplexen Strom $\underline{I}_{Fsub}$ und einer anschließenden Aufteilung in Imaginär- und Realteil, lässt sich die Reaktanz $X_{Lxy}$ bei dem zweipoligen Fehler wie folgt berechnen (Gleichung 6):

$$X_{Lxy} = \sin(\varphi) \frac{\mathrm{Im}\{\underline{U}_{LxLy} \cdot (\underline{I}_{Fsub} \cdot e^{j\delta_2})^*\}}{\mathrm{Im}\{\underline{Z}_L / |\underline{Z}_L| \cdot (\underline{I}_{Lx} - \underline{I}_{Ly}) \cdot (\underline{I}_{Fsub} \cdot e^{j\delta_2})^*\}} \qquad (6)$$

Für die Berechnung der für das Distanzschutzverfahren erforderlichen Resistanz $R_{Lxy}$ muss man die Formel (1) folgendermaßen umwandeln:

$$\underline{U}_{LxLy} = \underline{Z}_L(\underline{I}_{Lx} - \underline{I}_{Ly}) + \underline{I}_F \cdot R_F \big| \cdot [\underline{Z}_L(\underline{I}_{Lx} - \underline{I}_{Ly})]^* \qquad (7)$$

Nach dieser Umwandlung ergibt sich für den ohmschen Widerstand $R_F$ an der Fehlerstelle folgender Ausdruck:

$$R_F = \frac{\mathrm{Im}\{\underline{U}_{LxLy} \cdot [\{\underline{Z}_L(\underline{I}_{Lx} - \underline{I}_{Ly})]^*\}}{\mathrm{Im}\{I_F \cdot [\{\underline{Z}_L(\underline{I}_{Lx} - \underline{I}_{Ly})]^*\}} \qquad (8)$$

Da der Strom $\underline{I}_F$ an der Fehlerstelle nicht bekannt ist, wird bei dem zweipoligen Fehler eine Annäherung entsprechend Gleichung (3) für den Fehlerstrom eingesetzt und damit die Resistanz $R_{Lxy}$ bei einem zweipoligen Fehler ohne Erdbeteiligung ermittelt:

$$R_{Lxy} = \frac{\mathrm{Im}\{\underline{U}_{LxLy} \cdot [\{\underline{Z}_L(\underline{I}_{Lx} - \underline{I}_{Ly})]^*\}}{\mathrm{Im}\{2(\underline{a} - \underline{a}^2)\underline{I}_{2,A} \cdot [\{\underline{Z}_L(\underline{I}_{Lx} - \underline{I}_{Ly})]^*\}} \qquad (9)$$

Für die Phase-Phase Fehler mit Erdbeteiligung kann man auch die gleiche Formel wie bei einem Phase-Phase-Fehler ohne Erdbeteiligung nutzen (Gleichung 1).

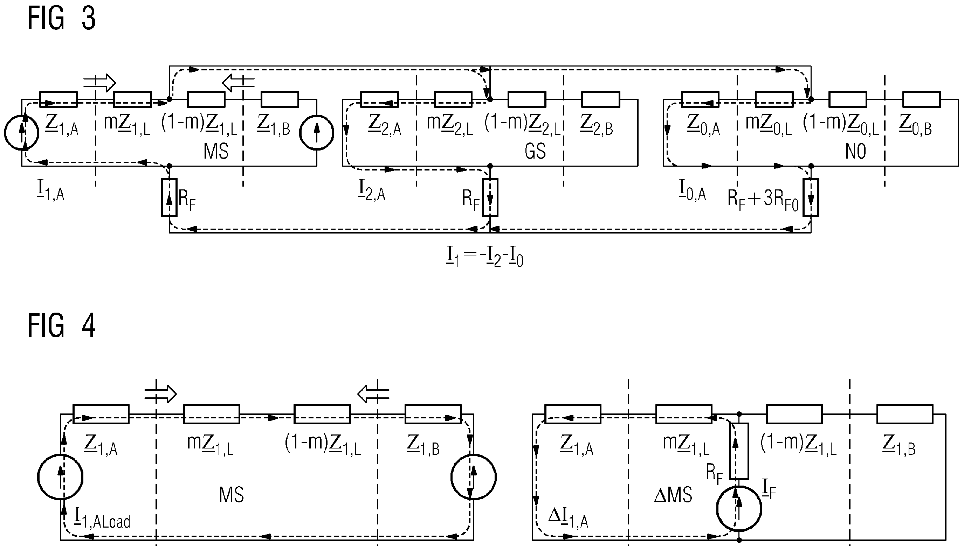

Betrachtet man nämlich das Ersatzschaltbild gemäß Fig. 3 mit symmetrischen Komponenten für diesen Fehlerfall, dann lässt sich der Kurzschlussstrom an der Fehlerstelle folgendermaßen darstellen:

$$\underline{I}_F = \underline{I}_{FLx} - \underline{I}_{FLy} = 2(\underline{a} - \underline{a}^2)\underline{I}_2 + (\underline{a} - \underline{a}^2)\underline{I}_0 \qquad (10)$$

Beide Komponenten $I_2$ und $I_0$, also der Strom im Gegensystem GS und der Strom im Nullsystem GO nach Fig. 3 lassen sich nicht von einem Ende messtechnisch erfassen. Der gesamte Fehlerstrom $\underline{I}_F$ muss approximiert werden.

Unter der Annahme, dass der Erdstrom wesentlich kleiner als der Gegensystemstrom ist und einen kleineren Einfluss auf den tatsächlichen Fehlerstrom hat, kann man wie im Fehlerfalle ohne Erdbeteiligung zuvor die Approximation gemäß Gleichung einsetzen:

$$\underline{I}_F = \underline{I}_{FLx} - \underline{I}_{FLy} = 2(\underline{a} - \underline{a}^2)\underline{I}_2 \qquad (11)$$

Die Formel zur Berechnung der Reaktanz ist identisch mit der Gleichung (6).

Für die Berechnung der Resistanz $R_{Lxy}$ wird folgende Gleichung benutzt:

$$R_{Lxy} = \frac{\text{Im}\{\underline{U}_{LxLy} \cdot [\{\underline{Z}_L(\underline{I}_{Lx} - \underline{I}_{Ly})\}]^*\}}{\text{Im}\{[2(\underline{a} - \underline{a}^2)\underline{I}_{2,A} + (\underline{a} - \underline{a}^2)\underline{I}_0] \cdot [\{\underline{Z}_L(\underline{I}_{Lx} - \underline{I}_{Ly})\}]^*\}} \qquad (12)$$
,

in der mit $(\underline{a}-\underline{a}^2)\underline{I}_0$ der Einfluss des Stroms im Nullsystem NO berücksichtigt ist.

Bei dreipoligen Fehlern darf kein Null- oder Gegensystem benutzt werden, weil diese Komponenten bei symmetrischen Fehlern nicht existieren. Aus diesem Grund, wird das Delta-Mitsystem genutzt. Dieses berechnet sich aus dem Vorfehlerund dem Fehlerzustand, wobei mit Vorfehlerzustand der Zustand der Energieübertragungsleitung L vor dem Auftreten des Fehlers gemeint ist. Die Fig. 4 zeigt diese beiden Zustände als Ersatzschaltbild.

Das linke Ersatzschaltbild stellt einen reinen Lastfall dar. Das rechte Ersatzschaltbild stellt den reinen Kurzschlussfall dar. Der Kurzschlussstrom an der Fehlerstelle wird dann durch die Delta-Komponente abgebildet:

$$\underline{I}_F = \Delta\underline{I}_1 \qquad (13)$$

Das Delta-Mitsystem wird mit dem Kompensationswinkel $\delta_2$ vom Gegensystem gedreht:

$$\underline{I}_F = \Delta\underline{I}_{1,A} \cdot e^{j\delta_2} \qquad (14)$$

Dabei wird angenommen, dass die Gegensystemimpedanz der Mitsystemimpedanz gleich ist. Analog zu der Berechnung von Phase-Phase-Impedanzen erhält man dann für die Berechnung der Reaktanz $X_L$ der Energieübertragungsleitung im Fehlerfall folgende Gleichung (15) und für die Berechnung der Resistanz $R_F$ die Beziehung (16):

$$X_L = \sin(\varphi)\frac{\text{Im}\{\underline{U}_{1,A} \cdot (\Delta\underline{I}_{1,A} \cdot e^{j\delta_2})^*\}}{\text{Im}\{\underline{Z}_{1A}/|\underline{Z}_{1A}| \cdot \underline{I}_{1,A} \cdot (\Delta\underline{I}_{1A} \cdot e^{j\delta_2})^*\}} \qquad (15)$$

$$R_F = \frac{\text{Im}\{\underline{U}_{1,A} \cdot [\underline{Z}_L\underline{I}_{1,A}]^*\}}{\text{Im}\{\Delta I_{1,A} \cdot [\underline{Z}_L\underline{I}_{1,A}]^*\}} \qquad (16)$$

wobei $\underline{U}_{1,A}$ die im Fehlerfall gemessene Spannung und $\underline{I}_{1,A}$ der im Fehlerfall in einer Phase gemessene Strom als Mitsystemgrößen sind.

Mit dem beschriebenen Verfahren in seinen verschiedenen Ausgestaltungen lässt sich die Reaktanz und auch die Resistanz einer von einem Fehler betroffenen, mehrphasigen Energieübertragungsleitung erheblich genauer als mit bekannten Methoden zur Impedanzermittlung bestimmen. Eine dieser Methoden ist z.B. im US4559491 offenbart.

Das eröffnet die Möglichkeit, den Fehlerort genau zu bestimmen, indem die richtige Einstellung für den Kompensationswinkel $\delta_2$, für das Gegensystem GS und das Nullsystem N0 eingestellt wird. Diese Größen lassen sich abschätzen, wenn eine Kommunikationsverbindung zum anderen Ende B der Energieübertragungsleitung L vorliegt. Folgende Größen sind von dem anderen Ende B notwendig, um einen genauen Fehlerort zu ermitteln: $\underline{Z}_{2,B}$ als Impedanz im Gegensystem GS bezogen auf das andere Ende B der Energieübertragungsleitung L, und $\Delta\underline{Z}_{1,B}$ als Impedanz im Delta-System bezogen auf das eine Ende A der Energieübertragungsleitung L. Diese Größen lassen sich einfach von den kurzschlussbehaften Strömen und Spannungen wie folgt ableiten bzw. messen:

$$\underline{Z}_{2,B} = \frac{\underline{U}_{2,B}}{\underline{I}_{2,B}}, \Delta\underline{Z}_{1,B} = \frac{\Delta\underline{U}_{1,B}}{\Delta\underline{I}_{1,B}} \qquad (17)$$

Es gelten dabei die bereits gezeigten Ersatzschaltbilder gemäß den Figuren 2 und 3. Bei einem vorwärtsgerichteten Fehler drücken die Impedanzen direkt die Vorimpedanzen der jeweiligen symmetrischen Komponente aus. Sie können dann zur Berechnung des Fehlerortes angewendet werden. Durch diese Information von dem weiteren Ende B wird der Kompensationswinkel $\delta_2$, nur von einer Unbekannten abhängig - nämlich dem Fehlerort m -, weil alle anderen Informationen zur Verfügung stehen.

Um den Fehlerort zu bestimmen, geht man von den Gleichungen (6) und (15) aus und berücksichtigt den Reaktanzbelag x' der Leitung L, der für die jeweilige Energieübertragungsleitung bekannt ist. Die genannten Gleichungen (6) und (15) werden jeweils mit dem Kehrwert des Reaktanzbelages x' multipliziert, so dass man für den zweipoligen und den dreipoligen Fehler die Funktionen (18) und (19) erhält; darum ist auch der Kompensationswinkel $\delta_2$, bekannt, weil er sich aus Gleichung (5) entnehmen lässt. Man erhält somit eine Funktion für den Fehlerort, $m = f_{Schleife}(m)$ nach Gauß oder $f_{Shleife}(m)-m=0$ nach Newton-Raphson die sich iterativ lösen lässt

$$f_{Lxy}(m) = \sin(\varphi) \frac{\mathrm{Im}\{\underline{U}_{LxLy} \cdot (\underline{I}_{Fsub} \cdot e^{j\delta_2(m)})^*\}}{x' \cdot \mathrm{Im}\{\underline{Z}_L /|\underline{Z}_L| \cdot (\underline{I}_{Lx} - \underline{I}_{Ly}) \cdot (\underline{I}_{Fsub} \cdot e^{j\delta_2(m)})^*\}} \quad (18)$$

$$f_L(m) = \sin(\varphi) \frac{\mathrm{Im}\{\underline{U}_{1,A} \cdot (\Delta\underline{I}_{1,A} \cdot e^{j\delta_2(m)})^*\}}{x' \cdot \mathrm{Im}\{\underline{Z}_1 /|\underline{Z}_1| \cdot \underline{I}_{1,A} \cdot (\Delta\underline{I}_{1,A} \cdot e^{j\delta_2(m)})^*\}} \quad (19)$$

Um die zu den obigen Berechnungen erforderlichen Informationen von dem weiteren Ende B der Energieübertragungsleitung L zu erhalten, muss eine Kommunikation zwischen beiden Enden A und B bzw. der Messwertaufbereitungseinrichtungen MA und MB und den Auswerteeinrichtungen AA und AB bestehen. Es handelt sich hier um einen Austausch von zwei Größen, nämlich $\Delta Z_{1,B}$ bzw. $\underline{\Delta Z}_{1,A}$ und $Z_{2,A}$ bzw. $Z_{2,B}$. Diese Größen sollen dann versendet werden, wenn an einem Ende der Energieübertragungsleitung eine Anregung erfolgt ist und ein Schutzgerät anregt, weil ein Fehler in Vorwärtsrichtung gesehen wird. Beim Versenden der Größen muss auch mitgeteilt werden, welche Schleifen angeregt sind. Die Größen werden in einem speziell dazu eingerichtetem Puffer ablegt und dann abgeholt, wenn die eigene Station die Fehlerortung durchführt. Das Versenden der Daten von dem jeweils anderen Ende kann immer zyklisch erfolgen. Dadurch wird gewährleistet, dass die mit der Fensterlänge entstandenen Messfehler minimiert werden. Die zeitliche Verzögerung ist hier unwichtig, weil die Bestimmung des Fehlerortes dann aufgerufen wird, wenn die Anregung zurückgeht. Der Fehlerorter der eigenen Station prüft danach, ob der Fehler auch vorwärts ist. Kommen keine Daten vom jeweils anderen Ende, wird der einseitige Fehlerorter aufgerufen.

In entsprechender Weise lässt sich im Rahmen der Erfindung auch der Ort des Fehlers bei einem einpoligen Fehler, also einem Phase-Erde-Fehler, bestimmen, wenn von einer Reaktanz $X_{LxE}$ für diesen Fehler gemäß der bekannten nachstehenden Beziehung ausgegangen wird

$$X_{LxE} = \sin(\varphi) \frac{\mathrm{Im}\{\underline{U}_{LxE} \cdot (\underline{I}_{Fsub} \cdot e^{j\delta(m)})^*\}}{x' \cdot \mathrm{Im}\{\underline{Z}_L /|\underline{Z}_L| \cdot (\underline{I}_{Lx} - \underline{K}_0 \underline{I}_E) \cdot (\underline{I}_{Fsub} \cdot e^{j\delta(m)})^*\}} \quad (20)$$

worin

$X_{LxE}$     Reaktanz der Phase-Erde-Schleife,
$\underline{Z}_L$     Leitungsimpedanz,
$\underline{U}_{LxE}$     Phase-Erde-Spannung,
$\underline{I}_{Lx}$     Phasenstrom,
$\varphi$     Leitungswinkel,
$\underline{I}_{Fsub}$     Polarisierungsgröße,
$\delta$     Kompensationswinkel,
$\underline{I}_E$     Erdstrom,
$\underline{K}_0$     komplexer Erdimpedanzfaktor.

bezeichnen.

Berücksichtigt man auch hier den Reaktanzbelag x' der Energieübertragungsleitung L, dann erhält man eine Gleichung für eine Funktion $f_{LxE}(m)$ des Fehlerortes, die sich durch die oben beschriebenen iterativen Verfahren lösen lässt:

$$f_{LxE}(m) = \sin(\varphi) \frac{\text{Im}\{\underline{U}_{LxE} \cdot (\underline{I}_{Fsub} \cdot e^{j\delta(m)})^*\}}{x' \cdot \text{Im}\{\underline{Z}_L / |\underline{Z}_L| \cdot (\underline{I}_{Lx} - \underline{K}_0 \underline{I}_E) \cdot (\underline{I}_{Fsub} \cdot e^{j\delta(m)})^*\}} \ . \tag{21}$$

**Patentansprüche**

1.  Verfahren zum Erkennen von Fehlern auf einer mehrphasigen elektrischen Energieübertragungsleitung (L) mittels Erfassung fehlerabhängiger Ströme und Spannungen, bei dem zur Bestimmung der Reaktanz ($X_{Lxy}$) der Energieübertragungsleitung (L) bei einem zweipoligen Fehler
    an einem Ende (E1) der Energieübertragungsleitung ein Phase-Phase-Spannungszeiger ($\underline{U}_{LxLy}$) der vom Fehler betroffenen Phasen, aus den Phasenströmen ($\underline{I}_{Lx}, \underline{I}_{Ly}$) in den vom Fehler betroffenen Phasen ein Differenzstromzeiger ($\underline{I}_{Lx} - \underline{I}_{Ly}$) sowie ein Fehlerstromzeiger ($\underline{I}_{Fsub}$) gebildet werden, der als eine Funktion des Gegensystems (GS) gemäß der Methode der symmetrischen Komponenten mit Abhängigkeit vom Gegensystemstrom und einem Kompensa-tionswinkel ($\delta_2$) für das Gegensystem (GS) dargestellt wird, **dadurch gekennzeichnet, dass** gemäß folgender Gleichung (10) die Reaktanz der Energieübertragungsleitung (L) bestimmt wird

$$X_{Lxy} = \sin(\varphi) \frac{\text{Im}\{\underline{U}_{LxLy} \cdot (\underline{I}_{Fsub} \cdot e^{j\delta_2})^*\}}{\text{Im}\{\underline{Z}_L / |\underline{Z}_L| \cdot (\underline{I}_{Lx} - \underline{I}_{Ly}) \cdot (\underline{I}_{Fsub} \cdot e^{j\delta_2})^*\}}$$

    mit

    $\underline{Z}_L$ als Impedanz der Energieübertragungsleitung (L),
    $\varphi$ als Phasenwinkel der Impedanz der Energieübertragungsleitung (L),
    Im als Bezeichnung für den Imaginärteil und
    *als konjugiert komplexer Anteil.

2.  Verfahren nach Anspruch 1, bei dem unter Ausbildung eines Distanzschutzverfahrens die Bestimmung der Resistanz $R_{Lxy}$ der Energieübertragungsleitung (L) bei dem Fehler gemäß der nachstehenden Gleichung erfolgt

$$R_{Lxy} = \frac{\text{Im}\{\underline{U}_{LxLy} \cdot [\{\underline{Z}_L (\underline{I}_{Lx} - \underline{I}_{Ly})\}]^*\}}{\text{Im}\{[2(\underline{a} - \underline{a}^2)\underline{I}_{2,A} + (\underline{a} - \underline{a}^2)\underline{I}_{0,A}] \cdot [\{\underline{Z}_L (\underline{I}_{Lx} - \underline{I}_{Ly})\}]^*\}}$$

    in der bezeichnen

    $\underline{a}$ einen komplexen Drehfaktor,
    $\underline{I}_{2,A}$ einen Mitsystemstrom der symmetrischen Komponenten und
    $\underline{I}_{0,A}$ einen Strom des Nullsystems (NO) der symmetrischen Komponenten,
    und die Resistanz $R_{Lxy}$ mit der Reaktanz $X_{Lxy}$ zur Impedanzbestimmung heran gezogen wird.

3.  Verfahren nach Anspruch 1 oder 2,
    **dadurch gekennzeichnet, dass** der Kompensationswinkel $\delta_2$ des Gegensystems (GS) gemäß der nachstehenden Gleichung bestimmt wird:

$$\delta_2 = \frac{\underline{Z}_{2,A} + \underline{Z}_{2,B} + \underline{Z}_{2,L}}{(1-m) \cdot \underline{Z}_{2,L} + \underline{Z}_{2,B}} \ ,$$

    in der bezeichnen

    $m$ den Fehlerort als Bruchteil der gesamten Länge der elektrischen Energieübertragungsleitung (L),
    $\underline{Z}_{2,A}$ die Impedanz im Gegensystem (GS) bezogen auf das eine Ende (A) der Energieübertragungsleitung (L),
    $\underline{Z}_{2,B}$ die Impedanz im Gegensystem (GS) bezogen auf das andere Ende (B) der Energieübertragungsleitung

(L) und

$\underline{Z}_{2,L}$ die Leitungsimpedanz im Gegensystem (GS).

4. Verfahren zum Erkennen von Fehlern auf einer mehrphasigen elektrischen Energieübertagungsleitung (L) mittels Erfassung fehlerabhängiger Ströme und Spannungen, bei dem zur Bestimmung der Reaktanz $X_{Lxy}$ der Energieübertragungsleitung (L) bei einem dreipoligen Fehler

an einem Ende (A) der Energieübertragungsleitung (L) aus den Phasenspannungen der Energieübertragungsleitung ein Mitsystemspannungs-Zeiger $\underline{U}_{1,A}$, aus den Phasenströmen ein Mitsystemstrom-Zeiger $\underline{I}_{1,A}$ und aus dem Mitsystemstrom-Zeiger vor dem Fehler und einem Mitsystemstrom-Zeiger während des Fehlers ein Deltastrom-Zeiger $\underline{\Delta I}_{1,A}$ unter Berücksichtigung des Kompensationswinkel $\delta_2$ für das Gegensystem (GS) gebildet werden, **dadurch gekennzeichnet, dass** gemäß folgender Gleichung die Reaktanz $X_L$ der Energieübertragungsleitung (L) bestimmt wird

$$X_L = \sin(\varphi) \frac{\text{Im}\{\underline{U}_{1,A} \cdot (\Delta\underline{I}_{1,A} \cdot e^{j\delta_2})^*\}}{\text{Im}\{\underline{Z}_1 / |\underline{Z}_1| \cdot \underline{I}_{1,A} \cdot (\Delta\underline{I}_{1,A} \cdot e^{j\delta_2})^*\}}$$

Mit

Z1 als Mitsystemimpedanz der Energieübertragungsleitung L, Im als Bezeichnung für den Imaginärteil und *als konjugiert komplexer Anteil.

5. Verfahren nach Anspruch 4, bei dem

bei dem unter Ausbildung eines Distanzschutzverfahrens die Bestimmung der Resistanz (R$_F$) der Energieübertragungsleitung (L) bei dem dreipoligen Fehler gemäß der nachstehenden Gleichung erfolgt

$$R_F = \frac{\text{Im}\{\underline{U}_1 \cdot [\underline{Z}_L \underline{I}_{1,A}]^*\}}{\text{Im}\{\Delta I_1 \cdot [\underline{Z}_L \underline{I}_{1,A}]^*\}} \; .$$

und die Resistanz (R$_F$) mit der Reaktanz (X$_L$) zur Impedanzbestimmung heran gezogen wird.

6. Verfahren nach Anspruch 4 oder 5,

der Kompensationswinkel $\delta_2$ des Gegensystems (GS) gemäß der nachstehenden Gleichung bestimmt wird:

$$\delta_2 = \frac{\underline{Z}_{2,A} + \underline{Z}_{2,B} + \underline{Z}_{2,L}}{(m-1) \cdot \underline{Z}_{2,L} + \underline{Z}_{2,B}} \; ,$$

in der bezeichnen

m den Fehlerort als Bruchteil der gesamten Länge der Energieübertragungsleitung (L),

$\underline{Z}_{2,A}$ die Impedanz im Gegensystem (GS) bezogen auf das eine Ende (A) der Energieübertragungsleitung (L),

$\underline{Z}_{2,B}$ die Impedanz im Gegensystem (GS) bezogen auf das andere

Ende (B) der Energieübertragungsleitung (L) und

$\underline{Z}_{2,L}$ die Leitungsimpedanz im Gegensystem (GS).

7. Verfahren nach Anspruch 1 und 3 oder nach Anspruch 4 oder 6, bei dem zum Erkennen von mehrpoligen Fehlern hinsichtlich ihres Fehlerortes auf der mehrphasigen elektrischen Energieübertagungsleitung (L)

eine den Reaktanzbelag der gesamten Energieübertragungsleitung (L) angebende Belag-Größe x' verwendet wird, die Reaktanz $X_{Lxy}$,$X_L$ der Energieübertragungsleitung (L) im Fehlerfall mit einem dem Kehrwert der Belag-Größe x' entsprechenden Wert multipliziert wird und

unter Ausnutzung der Fehlerortsabhängigkeit des Kompensationswinkels $\delta_2$ des Gegensystems (GS) der Fehlerort nach einem Iterationsverfahren bestimmt wird.

8. Verfahren nach Anspruch 7,

**dadurch gekennzeichnet, dass** das Iterationsverfahren nach der Gauß-Methode durchgeführt wird.

9. Verfahren nach Anspruch 7 oder 8,
bei dem während eines zweipoligen Fehlers an dem anderen Ende (B) der Energieübertragungsleitung (L) der Impedanz-Zeiger $\underline{Z}_{2,B}$ im Gegensystem (GS) aus dem Gegensystemspannungs-Zeiger $\underline{U}_{2,B}$ und dem Gegensystemstrom-Zeiger $\underline{I}_{2,B}$ gebildet und abgespeichert wird und mit der gespeicherten Information über den zweipoligen Fehler zu dem einen Ende (A) der Energieübertragungsleitung (L) übertragen wird.

10. Verfahren nach Anspruch 7 oder 8,
bei dem während eines dreipoligen Fehlers an dem anderen Ende (B) der Energieübertragungsleitung (L) der Impedanz-Zeiger $\Delta Z_{1,B}$ im Delta-Mitsystem aus dem Delta-Mitsystemspannungs-Zeiger $\Delta U_{1,B}$ und dem Delta-Mitsystemstrom-Zeiger $\Delta I_{1,B}$ gebildet und abgespeichert wird und mit der gespeicherten Information über den dreipoligen Fehler zu dem einen Ende (A) der Energieübertragungsleitung (L) übertragen wird.

11. Verfahren nach Anspruch 9 oder 10,
**dadurch gekennzeichnet, dass** der jeweils abgespeicherte Impedanz-Zeiger $\Delta Z_{1,B}$, $\underline{Z}_{2,B}$ und die jeweils gespeicherte Information über den zweipoligen Fehler über eine Datenleitung (D) zu dem einen Ende (A) der Energieübertragungsleitung (L) übertragen werden.

12. Anordnung zum Durchführen des Verfahrens nach einem der Ansprüche 7 bis 11,
**dadurch gekennzeichnet, dass** bei der an dem einen Ende (A) der mehrphasigen elektrischen Energieübertragungsleitung (L) eine Messwertaufbereitungs-Einrichtung (MA) vorhanden ist, die bei einem zweipoligen Fehler den Phase-Phase-Spannungszeiger $\underline{U}_{Lx,Ly}$, den Differenzstrom-Zeiger $\underline{I}_{Lx}$, - $\underline{I}_{Ly}$ und den Fehlerstromzeiger $\underline{I}_{Fsub}$ bildet und bei einem dreipoligen Fehler den Mitsystemspannungs-Zeiger $\underline{U}_{1,A}$, den Mitsystemstrom-Zeiger $\underline{I}_{1,A}$ und den Deltastrom-Zeiger $\Delta \underline{I}_{1,A}$ bildet und an dem anderen Ende (B) der Energieübertragungsleitung (L) eine weitere Messwertaufbereitungs-Einrichtung vorgesehen ist, die während eines zweipoligen Fehlers den Impedanz-Zeiger $\underline{Z}_{2,B}$ im Gegensystem bildet und abspeichert und bei einem dreipoligen Fehler den Impedanz-Zeiger $\Delta \underline{Z}_{2,B}$ im Delta-System bildet und abspeichert sowie eine Information über die Art des Fehlers speichert; ferner ist eine Datenübertragungseinrichtung zur Übertragung der in der weiteren Messwertaufbereitungseinrichtung gespeicherten Daten zu dem einen Ende der Energieübertragungsleitung vorhanden und an die eine Messwertübertragungseinrichtung ist eine auch mit der Datenübertragungseinrichtung verbundene Auswerteeinrichtung angeschlossen ist, die geeignet ist, den Ort des Fehlers bei einem zweipoligen Fehler gemäß der nachstehenden Gleichung

$$f_{Lxy}(m) = \sin(\varphi)\frac{\mathrm{Im}\{\underline{U}_{LxLy} \cdot (\underline{I}_{Fsub} \cdot e^{j\delta_2(m)})^*\}}{x' \cdot \mathrm{Im}\{\underline{Z}_L / |\underline{Z}_L| \cdot (\underline{I}_{Lx} - \underline{I}_{Ly}) \cdot (\underline{I}_{Fsub} \cdot e^{j\delta_2(m)})^*\}}$$

und bei einem dreipoligen Fehler gemäß der folgenden Gleichung

$$f_L(m) = \sin(\varphi)\frac{\mathrm{Im}\{\underline{U}_{1,A} \cdot (\Delta \underline{I}_{1,A} \cdot e^{j\delta_2(m)})^*\}}{x' \cdot \mathrm{Im}\{\underline{Z}_1 / |\underline{Z}_1| \cdot \underline{I}_{1,A} \cdot (\Delta \underline{I}_{1,A} \cdot e^{j\delta_2(m)})^*\}}$$

zu bestimmen.

13. Anordnung nach Anspruch 12,
**dadurch gekennzeichnet, dass** an die weitere Messwertaufbereitungs-Einrichtung (MA) eine weitere Auswerteeinrichtung (AB) angeschlossen ist, die entsprechend der einen Auswerteeinrichtung (AA) ausgebildet ist.

14. Anordnung nach Anspruch 12 oder 13,
**dadurch gekennzeichnet, dass** mindestens die eine Auswerteeinrichtung (AA) ein Personal Computer ist.

15. Anordnung nach einem der Ansprüche 12 bis 14,
**dadurch gekennzeichnet, dass** die Datenübertragungseinrichtung eine Datenübertragungsleitung (D) ist.

**Claims**

1. Method for detecting faults on a multiphase electrical energy transmission line (L) by capturing fault-dependent currents and voltages, in which, in order to determine the reactance ($X_{Lxy}$) of the energy transmission line (L) in the event of a two-pole fault at one end (E1) of the energy transmission line, a phase-phase voltage phasor ($\underline{U}_{LxLy}$) of the phases affected by the fault is formed, a differential current phasor ($\underline{I}_{Lx}$-$\underline{I}_{Ly}$) is formed from the phase currents ($\underline{I}_{Lx}$, $\underline{I}_{Ly}$) in the phases affected by the fault and a fault current phasor ($\underline{I}_{Fsub}$) is formed, which fault current phasor is represented as a function of the negative phase-sequence system (GS) according to the method of symmetrical components with dependence on the negative phase-sequence system current and a compensation angle ($\delta_2$) for the negative phase-sequence system (GS), **characterized in that** the reactance of the energy transmission line (L) is determined according to the following equation (10)

$$X_{Lxy} = \sin(\varphi) \frac{\mathrm{Im}\{\underline{U}_{LxLy} \cdot (\underline{I}_{Fsub} \cdot e^{j\delta_2})^*\}}{\mathrm{Im}\{\underline{Z}_L / |\underline{Z}_L| \cdot (\underline{I}_{Lx} - \underline{I}_{Ly}) \cdot (\underline{I}_{Fsub} \cdot e^{j\delta_2})^*\}}$$

where

$\underline{Z}_L$ is the impedance of the energy transmission line (L),
$\varphi$ is the phase angle of the impedance of the energy transmission line (L),
Im is the designation for the imaginary part, and
* is the complex conjugate part.

2. Method according to Claim 1,
in which, with the formation of a distance protection method, the resistance $R_{Lxy}$ of the energy transmission line (L) in the event of the fault is determined according to the following equation

$$R_{Lxy} = \frac{\mathrm{Im}\{\underline{U}_{LxLy} \cdot [\{\underline{Z}_L(\underline{I}_{Lx} - \underline{I}_{Ly})\}]^*\}}{\mathrm{Im}\{[2(\underline{a} - \underline{a}^2)\underline{I}_{2,A} + (\underline{a} - \underline{a}^2)\underline{I}_{0,A}] \cdot [\{\underline{Z}_L(\underline{I}_{Lx} - \underline{I}_{Ly})\}]^*\}}$$

in which

a denotes a complex rotation factor,
$\underline{I}_{2,A}$ denotes a positive phase-sequence system current of the symmetrical components, and
$\underline{I}_{0,A}$ denotes a current of the zero phase-sequence system (NO) of the symmetrical components,
and the resistance $R_{Lxy}$, with the reactance $X_{Lxy}$, is used to determine the impedance.

3. Method according to Claim 1 or 2,
**characterized in that**
the compensation angle $\delta_2$ of the negative phase-sequence system (GS) is determined according to the following equation:

$$\delta_2 = \frac{\underline{Z}_{2,A} + \underline{Z}_{2,B} + \underline{Z}_{2,L}}{(1-m) \cdot \underline{Z}_{2,L} + \underline{Z}_{2,B}}$$

in which

m denotes the fault location as a fraction of the total length of the electrical energy transmission line (L),
$\underline{Z}_{2,A}$ denotes the impedance in the negative phase-sequence system (GS) based on one end (A) of the energy transmission line (L),
$\underline{Z}_{2,B}$ denotes the impedance in the negative phase-sequence system (GS) based on the other end (B) of the energy transmission line (L), and
$\underline{Z}_{2,L}$ denotes the line impedance in the negative phase-sequence system (GS) .

4. Method for detecting faults on a multiphase electrical energy transmission line (L) by capturing fault-dependent currents and voltages, in which, in order to determine the reactance $X_{Lxy}$ of the energy transmission line (L) in the event of a three-pole fault at one end (A) of the energy transmission line (L), a positive phase-sequence system voltage phasor $\underline{U}_{1,A}$ is formed from the phase voltages of the energy transmission line, a positive phase-sequence system current phasor $\underline{I}_{1,A}$ is formed from the phase currents and a delta current phasor $\underline{\Delta I}_{1,A}$ is formed from the positive phase-sequence system current phasor before the fault and a positive phase-sequence system current phasor during the fault taking into account the compensation angle $\delta_2$ for the negative phase-sequence system (GS), **characterized in that** the reactance $X_L$ of the energy transmission line (L) is determined according to the following equation

$$X_L = \sin(\varphi) \frac{\operatorname{Im}\{\underline{U}_{1,A} \cdot (\Delta \underline{I}_{1,A} \cdot e^{j\delta_2})^*\}}{\operatorname{Im}\{\underline{Z}_1 / |\underline{Z}_1| \cdot \underline{I}_{1,A} \cdot (\Delta \underline{I}_{1,A} \cdot e^{j\delta_2})^*\}}$$

where

Z1 is the positive phase-sequence system impedance of the energy transmission line L,
Im is the designation for the imaginary part, and
* is the complex conjugate part.

5. Method according to Claim 4, in which
with the formation of a distance protection method, the resistance ($R_F$) of the energy transmission line (L) in the event of the three-pole fault is determined according to the following equation

$$R_F = \frac{\operatorname{Im}\{\underline{U}_1 \cdot [\underline{Z}_L \underline{I}_{1,A}]^*\}}{\operatorname{Im}\{\Delta I_1 \cdot [\underline{Z}_L \underline{I}_{1,A}]^*\}}$$

and the resistance ($R_F$), with the reactance ($X_L$), is used to determine the impedance.

6. Method according to Claim 4 or 5, in which the compensation angle $\delta_2$ of the negative phase-sequence system (GS) is determined according to the following equation:

$$\delta_2 = \frac{\underline{Z}_{2,A} + \underline{Z}_{2,B} + \underline{Z}_{2,L}}{(m-1) \cdot \underline{Z}_{2,L} + \underline{Z}_{2,B}}$$

in which

m denotes the fault location as a fraction of the total length of the energy transmission line (L),
$\underline{Z}_{2,A}$ denotes the impedance in the negative phase-sequence system (GS) based on one end (A) of the energy transmission line (L),
$\underline{Z}_{2,B}$ denotes the impedance in the negative phase-sequence system (GS) based on the other end (B) of the energy transmission line (L), and
$\underline{Z}_{2,L}$ denotes the line impedance in the negative phase-sequence system (GS) .

7. Method according to Claims 1 and 3 or according to Claim 4 or 6, in which, in order to detect multi-pole faults with respect to their fault location on the multiphase electrical energy transmission line (L),
a variable x' indicating the reactance per unit length of the entire energy transmission line (L) is used,
the reactance $X_{Lxy}$, $X_L$ of the energy transmission line (L) in the event of a fault is multiplied by a value corresponding to the reciprocal of the variable x', and
the fault location is determined according to an iteration method using the fault location dependence of the compensation angle $\delta_2$ of the negative phase-sequence system (GS).

8. Method according to Claim 7,
**characterized in that**
the iteration method is carried out according to Gauss' method.

9. Method according to Claim 7 or 8,
in which, during a two-pole fault at the other end (B) of the energy transmission line (L), the impedance phasor $\underline{Z}_{2,B}$ in the negative phase-sequence system (GS) is formed from the negative phase-sequence system voltage phasor $\underline{U}_{2,B}$ and the negative phase-sequence system current phasor $\underline{I}_{2,B}$ and is stored and is transmitted, with the stored information relating to the two-pole fault, to one end (A) of the energy transmission line (L).

10. Method according to Claim 7 or 8,
in which, during a three-pole fault at the other end (B) of the energy transmission line (L), the impedance phasor $\Delta\underline{Z}_{1,B}$ in the delta positive phase-sequence system is formed from the delta positive phase-sequence system voltage phasor $\Delta U_{1,B}$ and the delta positive phase-sequence system current vector $\Delta I_{1,B}$ and is stored and is transmitted, with the stored information relating to the three-pole fault, to one end (A) of the energy transmission line (L).

11. Method according to Claim 9 or 10,
**characterized in that**
the respectively stored impedance phasor $\Delta Z_{1,B}$, $\underline{Z}_{2,B}$ and the respectively stored information relating to the two-pole fault are transmitted to one end (A) of the energy transmission line (L) via a data line (D).

12. Arrangement for carrying out the method according to one of Claims 7 to 11,
**characterized in that**
there is a measured value preprocessing device (MA) at one end (A) of the multiphase electrical energy transmission line (L), which measured value preprocessing device forms the phase-phase voltage phasor $\underline{U}_{LxLy}$, the differential current phasor $\underline{I}_{Lx}$-$\underline{I}_{Ly}$ and the fault current phasor $\underline{I}_{Fsub}$ in the event of a two-pole fault and forms the positive phase-sequence system voltage vector $\underline{U}_{1,A}$, the positive phase-sequence system current vector $\underline{I}_{1,A}$ and the delta current vector $\Delta I_{1,A}$ in the event of a three-pole fault, and there is a further measured value preprocessing device at the other end (B) of the energy transmission line (L), which further measured value preprocessing device forms the impedance phasor $\underline{Z}_{2,B}$ in the negative phase-sequence system during a two-pole fault and stores it and forms the impedance phasor $\Delta\underline{Z}_{2,B}$ in the delta system in the event of a three-pole fault and stores it and stores an item of information relating to the type of fault; there is also a data transmission device for transmitting the data stored in the further measured value preprocessing device to one end of the energy transmission line and an evaluation device connected to the data transmission device is also connected to the one measured value preprocessing device and is suitable for determining the location of the fault according to the following equation in the event of a two-pole fault

$$f_{Lxy}(m) = \sin(\varphi)\frac{\mathrm{Im}\{\underline{U}_{LxLy}\cdot(\underline{I}_{Fsub}\cdot e^{j\delta_2(m)})^*\}}{x'\cdot\mathrm{Im}\{\underline{Z}_L/|\underline{Z}_L|\cdot(\underline{I}_{Lx}-\underline{I}_{Ly})\cdot(\underline{I}_{Fsub}\cdot e^{j\delta_2(m)})^*\}}$$

and according to the following equation in the event of a three-pole fault

$$f_L(m) = \sin(\varphi)\frac{\mathrm{Im}\{\underline{U}_{1,A}\cdot(\Delta\underline{I}_{1,A}\cdot e^{j\delta_2(m)})^*\}}{x'\cdot\mathrm{Im}\{\underline{Z}_1/|\underline{Z}_1|\cdot\underline{I}_{1,A}\cdot(\Delta\underline{I}_{1,A}\cdot e^{j\delta_2(m)})^*\}} .$$

13. Arrangement according to Claim 12,
**characterized in that**
a further evaluation device (AB) is connected to the further measured value preprocessing device (MA) and is designed in a manner corresponding to the one evaluation device (AA).

14. Arrangement according to Claim 12 or 13,
**characterized in that**
at least the one evaluation device (AA) is a personal computer.

**15.** Arrangement according to one of Claims 12 to 14,
**characterized in that**
the data transmission device is a data transmission line (D).

**Revendications**

**1.** Procédé de détection de défauts sur une ligne (L) de transport d'énergie électrique polyphasée en détectant des courants et des tensions qui dépendent du défaut, dans lequel, pour déterminer la réactance ($X_{Lxy}$) de la ligne (L) de transport d'énergie, s'il y a un défaut bipolaire à une extrémité (E1) de ligne de transport d'énergie, on forme un vecteur ($U_{LxLy}$) de tension phase-phase des phases concernées par le défaut, à partir des courants ($I_{Lx}, I_{Ly}$) de phase dans les phases concernées par le défaut un vecteur ($I_{Lx} - I_{Ly}$) de courant de différence, ainsi qu'un vecteur ($I_{Fsub}$) de courant de défaut, qui est représenté sous la forme d'une fonction du système (GS) inverse suivant la méthode des composantes symétriques en fonction du courant de système inverse et d'un angle ($\delta_2$) de compensation pour le système (GS) inverse,
**caractérisé en ce que**
on détermine, selon l'équation (10) suivante, la réaction de la ligne (L) de transport d'énergie

$$X_{Lxy} = \sin(\varphi) \frac{\operatorname{Im}\{U_{LxLy} \cdot (I_{Fsub} \cdot e^{j\delta_2})^*\}}{\operatorname{Im}\{Z_L / |Z_L| \cdot (I_{Lx} - I_{Ly}) \cdot (I_{Fsub} \cdot e^{j\delta_2})^*\}}$$

dans laquelle

$Z_L$ désigne l'impédance de la ligne (L) de transport d'énergie,
$\varphi$ désigne l'angle de phase de l'impédance de la ligne (L) de transport d'énergie,
Im désigne la partie imaginaire et
* désigne la partie complexe conjuguée.

**2.** Procédé suivant la revendication 1,
dans lequel, en formant un procédé de protection de distance, on effectue la détermination de la résistance $R_{Lxy}$ de la ligne (L) de transport d'énergie, s'il y a un défaut selon l'équation suivante

$$R_{Lxy} = \frac{\operatorname{Im}\{U_{LxLy} \cdot [\{Z_L (I_{Lx} - I_{Ly})\}^*]\}}{\operatorname{Im}\{[2(a - a^2)I_{2,A} + (a - a^2)I_{0,A}] \cdot [\{Z_L (I_{Lx} - I_{Ly})\}^*]\}}$$

$a$ désigne un facteur de rotation complexe,
$I_{2,A}$ désigne un courant de système direct des composantes symétriques et
$I_{0,A}$ désigne un courant du système (N0) nul des composantes symétriques,

et on met à profit la résistance $R_{Lxy}$ avec la réactance $X_{Lxy}$ pour la détermination de l'impédance.

**3.** Procédé suivant la revendication 1 ou 2,
**caractérisé en ce que**
on détermine l'angle $\delta_2$ de compensation du système (GS) inverse selon l'équation suivante :

$$\delta_2 = \frac{Z_{2,A} + Z_{2,B} + Z_{2,L}}{(1 - m) \cdot Z_{2,L} + Z_{2,B}}$$

dans laquelle

$m$ désigne l'emplacement du défaut sous la forme d'une fraction de la longueur totale de la ligne (L) de transport d'énergie électrique,
$Z_{2,A}$ désigne l'impédance dans le système (GS) opposé rapporté à la une extrémité (A) de la ligne (L) de

transport d'énergie,

$\underline{Z}_{2,B}$ désigne l'impédance dans le système (GS) opposé rapporté à l'autre extrémité (B) de la ligne (L) de transport d'énergie et

$\underline{Z}_{2',L}$ désigne l'impédance de la ligne dans le système (GS) opposé.

4. Procédé de détection de défauts sur une ligne (L) de transport d'énergie électrique polyphasée en détectant des courants et des tensions qui dépendent du défaut, dans lequel, pour déterminer la réactance $X_{Lxy}$ de la ligne (L) de transport d'énergie, s'il y a un défaut tripolaire à une extrémité (A) de la ligne (L) de transport d'énergie, on forme à partir des tensions de phase de la ligne de transport d'énergie un vecteur $\underline{U}_{1,A}$ de tension de système direct, à partir des courants de phase un vecteur $\underline{I}_{1,A}$ de courant de système direct et à partir du vecteur du courant de système direct avant le défaut et d'un vecteur de système de courant direct pendant le défaut un vecteur $\underline{\Delta I}_{1,A}$ de courant delta en tenant compte de l'angle $\delta_2$ de compensation pour le système (GS) opposé, **caractérisé en ce que** on détermine la réactance $X_L$ de la ligne (L) de transport d'énergie selon l'équation suivante

$$X_L = \sin(\varphi) \frac{\text{Im}\{\underline{U}_{1,A} \cdot (\Delta\underline{I}_{1,A} \cdot e^{j\delta_2})^*\}}{\text{Im}\{\underline{Z}_1 / |\underline{Z}_1| \cdot \underline{I}_{1,A} \cdot (\Delta\underline{I}_{1,A} \cdot e^{j\delta_2})^*\}}$$

dans laquelle

$\underline{Z}_1$ désigne l'impédance de système direct de la ligne (L) de transport d'énergie,
$Im$ désigne la partie imaginaire et
* désigne la partie complexe conjuguée.

5. Procédé suivant la revendication 4, dans lequel en formant un procédé de protection de distance, on effectue la détermination de la résistance ($R_F$) de la ligne (L) de transport d'énergie, s'il y a un défaut tripolaire, selon l'équation suivante

$$R_F = \frac{\text{Im}\{\underline{U}_1 \cdot [\underline{Z}_L \underline{I}_{1,A}]^*\}}{\text{Im}\{\Delta\underline{I}_1 \cdot [\underline{Z}_L \underline{I}_{1,A}]^*\}}$$

et on tire parti de la résistance ($R_F$) avec la réactance ($X_L$) pour la détermination d'impédance.

6. Procédé suivant la revendication 4 ou 5,
dans lequel on détermine l'angle $\delta_2$ de compensation du système (GS) opposé selon l'équation suivante

$$\delta_2 = \frac{\underline{Z}_{2,A} + \underline{Z}_{2,B} + \underline{Z}_{2,L}}{(m-1) \cdot \underline{Z}_{2,L} + \underline{Z}_{2,B}}$$

dans laquelle

$m$ désigne l'emplacement du défaut sous la forme d'une fraction de la longueur totale de la ligne (L) de transport d'énergie,

$\underline{Z}_{2,A}$ désigne l'impédance dans le système (GS) opposé rapporté à la une extrémité (A) de la ligne (L) de transport d'énergie,

$\underline{Z}_{2,B}$ désigne l'impédance dans le système (GS) opposé rapporté à l'autre extrémité (B) de la ligne (L) de transport d'énergie et

$\underline{Z}_{2,L}$ désigne l'impédance de la ligne dans le système (GS) opposé.

7. Procédé suivant la revendication 1 et 3 ou suivant la revendication 4 ou 6, dans lequel, pour détecter des défauts multipolaires en ce qui concerne leur emplacement sur la ligne (L) de transport d'énergie électrique polyphasée, on utilise une grandeur x' linéique indiquant la réactance linéique de toute la ligne (L) de transport d'énergie, on multiplie la réactance $X_{Lxy}$, $X_L$ de la ligne (L) de transport d'énergie en cas de défaut par une valeur correspondant à l'inverse de la grandeur x' linéique et

en utilisant la dépendance à l'emplacement du défaut de l'angle $\delta_2$ de compensation du système (GS) opposé, on détermine l'emplacement du défaut par un procédé par itération.

8. Procédé suivant la revendication 7,
**caractérisé en ce que**
on effectue le procédé par itération par la méthode de Gauss.

9. Procédé suivant la revendication 7 ou 8,
dans lequel, pendant un défaut bipolaire à l'autre extrémité (B) de la ligne (L) de transport d'énergie, on forme le vecteur $\underline{Z}_{2,B}$ d'impédance dans le système (GS) opposé à partir du vecteur $\underline{U}_{2,B}$ de tension du système opposé et du vecteur $\underline{I}_{2,B}$ de courant du système opposé et on le mémorise et on le transmet avec l'information mémorisée sur le défaut bipolaire à la une extrémité (A) de la ligne (L) de transport d'énergie.

10. Procédé suivant la revendication 7 ou 8,
dans lequel, pendant un défaut tripolaire à l'autre extrémité (B) de la ligne (L) de transport d'énergie, on forme le vecteur $\varDelta Z_{1,B}$ d'impédance dans le système direct delta à partir du vecteur $\varDelta U_{1,B}$ de système direct delta et du vecteur $\varDelta I_{1,B}$ de courant de système direct delta et on le mémorise et on le transmet avec l'information mémorisée sur le défaut tripolaire à la une extrémité (A) de la ligne (L) de transport d'énergie.

11. Procédé suivant la revendication 9 ou 10,
**caractérisé en ce que**
on transmet le vecteur $\varDelta Z_{1,B}$, $\underline{Z}_{2,B}$ mémorisé et l'information mémorisée sur le défaut bipolaire par une ligne (D) de données à la une extrémité (A) de la ligne (L) de transport d'énergie.

12. Agencement pour effectuer le procédé suivant l'une des revendications 7 à 11,
**caractérisé en ce que**
il y a, à la une extrémité (A) de la ligne (L) de transport d'énergie électrique polyphasée, un dispositif (MA) de traitement de valeurs de mesure, qui, pour un défaut bipolaire, forme le vecteur $\underline{U}_{Lx,Ly}$ de tension phase-phase, le vecteur $\underline{I}_{Lx}$, $\underline{I}_{Ly}$ de courant de différence et le vecteur $\underline{I}_{Fsub}$ de courant de défaut et, pour un défaut tripolaire, forme le vecteur $\underline{U}_{1,A}$ de tension de système direct, le vecteur $\underline{I}_{1,A}$ de courant de système direct et le vecteur $\varDelta \underline{I}_{1,A}$ de courant delta et il est prévu, à l'autre extrémité (B) de la ligne (L) de transport d'énergie, un autre dispositif (10) de traitement de valeurs de mesure, qui, pendant un défaut bipolaire, forme le vecteur $\underline{Z}_{2,B}$ d'impédance dans le système opposé et le mémorise et, pour un défaut tripolaire, forme le vecteur $\varDelta Z_{2,B}$ d'impédance dans le système delta et le mémorise, ainsi que mémorise une information sur le type du défaut, il est prévu, en outre, un dispositif de transfert de données pour le transfert des données mémorisées dans l'autre dispositif de traitement de valeurs de données à la une extrémité de la ligne de transport d'énergie et il est raccordé, pour un dispositif de transfert de valeurs de mesure, un dispositif d'exploitation relié également au dispositif de transfert de données et propre à déterminer l'emplacement du défaut pour un défaut bipolaire, selon l'équation suivante

$$f_{Lxy}(m) = \sin(\varphi) \frac{\operatorname{Im}\{\underline{U}_{LxLy} \cdot (\underline{I}_{Fsub} \cdot e^{j\delta_2(m)})^*\}}{x' \cdot \operatorname{Im}\{\underline{Z}_L / |\underline{Z}_L| \cdot (\underline{I}_{Lx} - \underline{I}_{Ly}) \cdot (\underline{I}_{Fsub} \cdot e^{j\delta_2(m)})^*\}}$$

et pour un défaut tripolaire, selon l'équation suivante

$$f_L(m) = \sin(\varphi) \frac{\operatorname{Im}\{\underline{U}_{1,A} \cdot (\varDelta \underline{I}_{1,A} \cdot e^{j\delta_2(m)})^*\}}{x' \cdot \operatorname{Im}\{\underline{Z}_1 / |\underline{Z}_1| \cdot \underline{I}_{1,A} \cdot (\varDelta \underline{I}_{1,A} \cdot e^{j\delta_2(m)})^*\}}$$

13. Agencement suivant la revendication 12,
**caractérisé en ce que**
il est raccordé, à l'autre dispositif (MA) de traitement de valeurs de mesure, un autre dispositif (AB) d'exploitation, qui est constitué conformément au un dispositif (AA) d'exploitation.

14. Agencement suivant la revendication 12 ou 13,
**caractérisé en ce que**

au moins le un dispositif (AA) d'exploitation est un personal computer.

15. Agencement suivant l'une des revendications 12 à 14,
**caractérisé en ce que**
le dispositif de transfert de données est une ligne (D) de transfert de données.

FIG 1

FIG 2

FIG 3

FIG 4

**IN DER BESCHREIBUNG AUFGEFÜHRTE DOKUMENTE**

*Diese Liste der vom Anmelder aufgeführten Dokumente wurde ausschließlich zur Information des Lesers aufgenommen und ist nicht Bestandteil des europäischen Patentdokumentes. Sie wurde mit größter Sorgfalt zusammengestellt; das EPA übernimmt jedoch keinerlei Haftung für etwaige Fehler oder Auslassungen.*

**In der Beschreibung aufgeführte Patentdokumente**

- DE 19605022 A1
- US 4559491 A